# EUROPEAN PATENT APPLICATION

(11) **EP 2 816 576 A1**
(43) Date of publication of application: **24.12.2014**
(21) Application number: 13460039.4
(22) Date of filing: 27.06.2013
(51) Int. Cl.: H01G 11/46, H01G 11/86

(54) **Method of manufacturing of an electrode oxide material, the electrode oxide material and the applications of the electrode oxide material**

(30) Priority: 19.06.2013 PL 40438113
(71) Applicant: Instytut Elektrotechniki, 04-703 Warzawa (PL)
(72) Inventor: Szubzda, Bronislaw, 50-322 Wroclaw (PL); Ozimek, Mariusz, 37-600 Lubaczow (PL); Janas, Katarzyna, 51-662 Wroclaw (PL); Gaworska-Koniarek, Dominika, 50-372 Wroclaw (PL)
(74) Representative: Kozlowska, Regina

(57) **Abstract**

The subject of this invention is a method of manufacturing of an electrode oxide material, the electrode oxide material and the applications of the electrode oxide material intended for electrodes of supercapacitors of MeO type, made by magnetron sputtering method.

The method consists in that inside a working chamber at least one metal current collector or a metal current collector coated with a carbon layer with a developed surface is placed and the surface of the current collector is positioned at a distance of 50 mm - 120 mm from the target made of the sputtered metal, where at a reactive gas atmosphere at the pressure of 0.4 Pa to 2.0 Pa and the power of 0.5 kW to 2.0 kW dissipated in the target, a thin metal electrode from a metal oxide (Me)ₓOₙ₋ₓ, with the thickness of 20 nm to 500 nm is deposited, whereby the deposited oxide layer is porous and has a developed surface. The electrode oxide material is a porous layer of metal oxide (Me)ₓOₙ₋ₓ, with highly developed surface, porosity above 40% and the layer thickness of 20 nm to 500 nm. The electrode oxide material is employed for the manufacturing of the electrodes of pseudo-capacity supercapacitors.

## Description

The subject of this invention is a method of manufacturing of an electrode oxide material, the electrode oxide material and the applications of the electrode oxide material intended for electrodes of supercapacitors of MeO type made by magnetron sputtering method. Supercapacitors are important components used in modem power dissipation systems. They enable short-time storage of high amount of electric energy that may be rapidly redistributed according to the needs. Supercapacitors are the subject of intensive research works in the field of widely understood materials engineering due to the widespread range of potential applications, such as components of kinetic energy recuperation systems in electric vehicles, energy buffers coupled with long-term energy stores and modules of UPS suppliers.

There are two main mechanisms of energy storage in supercapacitors: the first one associated with an electrostatic process of double electric layer formation at the electrode/electrolyte interface, and the second one associated with pseudo-capacity processes, consisting in charge exchange between the electrode and the electrolyte particles. The processes enhance by several times capacity of a capacitor and their mechanism is associated, among others, with the change in the oxidation degree of an electrode material as a result of an applied electric field.

Transition metal oxides (among others MnO₂, Fe₂O₃, InO₂, V₂O₅, RuO₂) can be employed as materials showing pseudo-capacity in suprcapacitors either in two-electrode systems or in asymmetric systems with carbon electrode as was reported, among the others, by A. Malak, K. Fic, G. Lota, C. Vix-Guterl, E. Fr 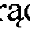 ckowiak in *Journal of Solid State Electrochemistry* 14 (2010) 811-816, or in a form of composite composed of a layer of a porous material (here the carbon one) and metal oxide, which was described in US 7572542 patent application *"Nanocarbon composite structure having ruthenium oxide trapped therein"* by Naoi Katsuhiko in 2008. The particles of ruthenium oxide are there distributed in graphene layers. Another form of a composite composed of a metal oxide and carbon nanopipes was reported in US 2010055568A1 patent application *"Transition metal oxides*/*multi-walled carbon nanotube nanocomposite and method for manufacturing the same"* by K. Dong-Wan, L.Du-Hee, K. Jin Gu, C. Kyoung Jin, P. Jae-Gwan in 2010.

Application of carbon materials containing heteroatoms such as oxygen or nitrogen, where pseudo-capacity is achieved due to redox processes of functional groups and local changes in electronic structure of electronic matrix doped with heteroatoms was reported in *"*High power supercapacitors using polyacrylonitrile-based carbon nanofiber paper" by E. J. Ra, E. Rajmundo-Pinero, Y. H. Lee , F. Beduin, Carbon 47 (2009) 2984-2992.

Currently, the methods of manufacturing of metal oxides for the applications in supercapacitors, being the subject of our interest, consist in employing a sol-gel method with the use of appropriate precursors, wherein the input material is transformed into sol in an ambient of water or diluted solution of a water acid, followed by transformation into gel after removing the liquid. The so-prepared gel is subjected to calcination, i.e. annealing in the temperature below the melting point of the compound, to remove the residual liquid. In this way, a monomolecular metal oxide is obtained. To manufacture an electrode of a supercapacitor, the obtained powder is deposited onto the surface of a current collector by means of different techniques such as spin-coating or dip coating.

Another way of deposition of a metal oxide for supercapacitor applications, directly on a current collector is the application of numerous electrochemical techniques. Such a method is reported in the WO02056325 patent application from 2002, by Lih-Ren, W. Nae-Lih, W. Dien-Shi, CH. Ching-Wen, L.Yi-Ping.

The oxide layer may be deposited by electroplating; it can be also obtained in a two-stage process: the first step is therein the deposition of a layer of an appropriate thickness on a collector. It is made by vacuum evaporation or electroplating. Then, by electrochemical oxidation in an appropriate solution, the metal surface is modified and an oxide is obtained.

Main inconveniences of those methods of oxide coatings manufacturing is their relative complexity: each of them involves at least two independent stages, and a little influence on the control of the structure and morphology of obtained layer, which is especially important in the case of materials for supercapacitors.

The essence of the method, according to the invention, consists in the fact that inside a working chamber at least one metal current collector or a metal current collector coated with a carbon layer with a developed surface is placed and the surface of the current collector is positioned at a distance of 50 mm - 120 mm from the target made of the sputtered metal, where at a reactive gas atmosphere at the pressure of 0.4 Pa to 2.0 Pa and the power of 0.5 kW to 2.0 kW dissipated in the target, a thin metal electrode from a metal oxide (Me)ₓOₙ₋ₓ, with the thickness of 20 nm to 500 nm is deposited, whereby the deposited oxide layer is porous and has a developed surface.

Advantageously, the deposited electrode is from a metal oxide FeₓOₙ₋ₓ, where x is less than 2 and n is less than or equal to 3, or from a titanium oxide TiOₓ, where x is less than 2.

Advantageously, the target is supplied with a unidirectional alternating current with an amplitude of 8 A, frequency of *f* = 160 kHz, with additional pulse group modulation with rectangular pulses of 1 kHz.

Advantageously, the (Me)ₓOₙ₋ₓ electrode of metal oxide is deposited in oxygen or argon atmosphere.

Advantageously, the metal oxide deposition is preceded by cleaning up the collector surface in cathode glow discharge.

According to the invention, the essence of the material consists in the fact that it is porous, advantageously with the porosity above 40%, the layer is made of metal oxide (Me)ₓOₙ₋ₓ with a highly developed surface, whereas the thickness of the layer ranges from 20 nm to 500 nm.

Advantageously, the metal oxide has either crystalline or amorphous structure or has a two-phase form, wherein the crystalline phase is surrounded by the amorphous one.

Advantageously, the metal oxide is a ferric oxide, FeₓOₙ₋ₓ, where x is less than 2 and n is less than or equal to 3, or a titanium oxide TiOₓ, where x is less than 2.

The essence of the invention is the use of the produced oxide material as a material for electrodes of a pseudo-capacity super capacitor.

The method of manufacturing of the oxide electrode material solves the problem of manufacturing of pseudo-capacity oxide materials. The obtained porous material is an excellent electric conductor and does not take part in electrochemical processes.

The metallic target is bombarded with high energy ions of a reactive gas which results in kinetic sputtering of atoms from the surface. The sputtered atoms are displaced in the vacuum chamber and deposit on the metallic current collector. The high-energy ions of reactive gas come from the glow discharge, initiated directly over the target. Thanks to appropriate selection of process parameters such as: target power, reactive gas pressure, reactive gas flow, it is possible to control the stoichiometry as well as structural and morphological properties of the obtained oxide layers, which is very important in terms of their pseudo-capacity properties.

The subject of the invention is explained on the examples of realization.

### Example 1

A method of manufacturing of an electrode material consisting in that inside a working chamber of a magnetron, a metal current collector is placed, whereby the surface of the current collector is situated at a distance of 75 mm from a titanic target (99.99% Ti) being a cathode of the magnetron, wherein in an atmosphere of pure oxygen (99.999% O₂) at a pressure of 2.0 Pa a metal oxide electrode of TiOₓ, where x is less than 2, with the thickness of 20 nm, is deposited. The magnetron cathode is supplied with a unidirectional alternating current with an amplitude of 8 A and frequency of *f* = 160 kHz. The deposited oxide layer is porous with highly developed surface.

### Example 2

A method of manufacturing of an electrode oxide material is the same as in Example 1 with the difference that the target with a diameter of 107 mm is made from iron (99.99% Fe) and the current collector is placed at a distance of 50 mm from the target. The deposited layer is porous, with a highly developed surface and is made of ferric oxide FeₓOₙ₋ₓ, where x is less than 2 and n is less or equal to 3. Furthermore, the target is supplied with a unidirectional alternating current with an amplitude less than 8 A, frequency of *f* = 160 kHz, with additional pulse group modulation with rectangular pulses of 1 kHz.

### Example 3

A method of manufacturing of an electrode oxide material is the same as in Examples 1 and 2 with the difference that the electrode of metal oxide (Me)ₓOₙ₋ₓ, is deposited in the atmosphere of oxygen and argon, under the pressure of 0.4 Pa and power dissipated in the target of 0.5 kW, furthermore, the surface of current collector is cleaned up before the metal oxide deposition in cathode glow discharge.

### Example 4

A method of manufacturing of an electrode oxide material is the same as in Examples 1 and 2 with the difference that the electrode of metal oxide (Me)ₓOₙ₋ₓ, is deposited in the atmosphere of oxygen and argon under the pressure of 2.0 Pa and at a power dissipated in the target of 2.0 kW.

### Example 5

A method of manufacturing of an electrode oxide material is the same as in Examples 1 and 2 with the difference that the surface of the current collector is placed at the distance of 120 mm from the target.

### Example 6

The oxide electrode material is a porous layer of ferric oxide, FeₓOₙ₋ₓ, with an amorphous structure, where x is less than 2 and n is less than or equal to 3; the layer with highly developed surface has a thickness of 20 nm

### Example 7

The oxide electrode material is made as in Example 4 with the difference that the porous layer made of titanium oxide TiOₓ, where x is less than 2, has a crystalline structure and a thickness of 500 nm.

### Example 8

The oxide electrode material is made as in Example 4 with the difference that the porous layer made of metal oxide (Me)ₓOₙ₋ₓ, has a two-phase form, wherein the crystalline phase is surrounded by the amorphous one; furthermore, the porosity of the metal oxide coating amounts to 40%.

### Example 9

The oxide electrode material manufactured according to the description in Examples 1 and 3 is employed as an electrode of a pseudo-capacity supercapacitor.

## Claims

1. A method of manufacturing of an electrode oxide material **characterized in that** inside a working chamber at least one metal current collector or a metal current collector coated with a carbon layer with a developed surface is placed, and the surface of the current collector is positioned at a distance of 50 mm - 120 mm from the target made of the sputtered metal, where at a reactive gas atmosphere at the pressure of 0.4 Pa to 2.0 Pa and the power of 0.5 kW to 2.0 kW dissipated in the target, a thin metal electrode from a metal oxide (Me)ₓOₙ₋ₓ, with the thickness of 20 nm to 500 nm is deposited, whereby the deposited oxide layer is porous and has a developed surface.

2. The method, according to claim 1, **characterized in that** the electrode is deposited from ferric oxide, FeₓOₙ₋ₓ, where x is less than 2 and n is less than or equal to 3.

3. The method, according to claim 1, **characterized in that** the electrode is deposited from a titanium oxide TiOₓ, where x is less than 2.

4. The method, according to claim 1, **characterized in that** the target is supplied with a unidirectional alternating current with an amplitude below 8 A, frequency of f = 160 kHz, with additional pulse group modulation with rectangular pulses of 1 kHz.

5. The method, according to claim 1, **characterized in that** the electrode from a metal oxide (Me)ₓOₙ₋ₓ, is deposited in oxygen atmosphere.

6. The method, according to claim 1, **characterized in that** the electrode from a metal oxide (Me)ₓOₙ₋ₓ, is deposited in oxygen and argon atmosphere.

7. The method, according to claim 1, **characterized in that** before the deposition of metal oxide, the surface of current collector is cleaned up in cathode glow discharge.

8. An electrode oxide material, **characterized in that** it has a form of a porous layer of a metal oxide (Me)ₓOₙ₋ₓ, with highly developed surface and thickness of 20 nm to 500 nm.

9. A material according to claim 8, **characterized in that** the metal oxide has a crystalline structure

10. A material according to claim 8, **characterized in that** the metal oxide has an amorphous structure.

11. A material according to claim 8, **characterized in that** the metal oxide has a two-phase form, wherein the crystalline phase is surrounded by the amorphous one.

12. A material according to claim 8, **characterized in that** the metal oxide is a ferric oxide, FeₓOₙ₋ₓ, where x is less than 2 and n is less than or equal to 3.

13. A material according to claim 8, **characterized in that** the metal oxide is a titanium oxide TiOₓ, where x is less than 2.

14. A material according to claim 8, **characterized in that** porosity of the metal oxide covering the current collector is higher than 40%.

15. The oxide electrode material manufactured according to the claims 1 - 7 is employed as an electrode of a pseudo-capacity supercapacitor.
